(19) **Europäisches Patentamt**
**European Patent Office**
**Office européen des brevets**

(11) **EP 3 113 362 B1**

(12) # FASCICULE DE BREVET EUROPEEN

(45) Date de publication et mention
de la délivrance du brevet:
**03.01.2018 Bulletin 2018/01**

(51) Int Cl.:
***H03H 9/02*** *(2006.01)*

(21) Numéro de dépôt: **16158390.1**

(22) Date de dépôt: **03.03.2016**

(54) **DISPOSITIF A ONDES ELASTIQUES DE SURFACE COMPRENANT UN FILM PIEZOELECTRIQUE MONOCRISTALLIN ET UN SUBSTRAT CRISTALLIN, A FAIBLES COEFFICIENTS VISCOELASTIQUES**

VORRICHTUNG MIT ELASTISCHEN OBERFLÄCHEWELLEN, DIE EINEN PIEZOELEKTRISCHEN MONOKRISTALLINEN FILM UMFASST, UND KRISTALLINES SUBSTRAT MIT SCHWACHEN VISKOELASTISCHEN KOEFFIZIENTEN

DEVICE WITH ELASTIC SURFACE WAVES COMPRISING A SINGLE-CRYSTAL PIEZOELECTRIC FILM AND A CRYSTALLINE SUBSTRATE, WITH LOW VISCOELASTIC COEFFICIENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.03.2015 FR 1551803**

(43) Date de publication de la demande:
**04.01.2017 Bulletin 2017/01**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **GROUSSET, Sébastien**
**75014 PARIS (FR)**

• **BALLANDRAS, Sylvain**
**25000 BESANCON (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:

| | |
|---|---|
| EP-A1- 0 635 938 | WO-A1-2014/010696 |
| DE-A1-102009 001 192 | US-A- 5 446 330 |
| US-A1- 2004 135 650 | US-A1- 2010 156 241 |

Remarques:
Le dossier contient des informations techniques présentées postérieurement au dépôt de la demande et ne figurant pas dans le présent fascicule.

**Description**

Le domaine de l'invention est celui des dispositifs à ondes élastiques de surface et plus particulièrement celui des résonateurs à ondes élastiques de surface. De tels résonateurs présentent des coefficients de qualité élevés (> 10000) à des fréquences de quelques centaines de MHz à quelques GHz. Leur utilisation est particulièrement avantageuse dans des boucles d'oscillations destinées à la synthèse de fréquences ou de références de temps stables et compactes pour applications embarquées.

De manière générale, les composants utilisant des ondes de surface dénommés couramment composants SAW pour « Surface Acoustic Wave » sont bien connus et présents dans de nombreuses applications. Parmi celles-ci, on peut citer celle du traitement du signal, et notamment le filtrage de bande. Ces composants peuvent également constituer des dispositifs d'identification par radiofréquences (SAW-tags ou étiquettes à ondes de surface). Ils peuvent aussi être utilisés pour réaliser des capteurs de différentes grandeurs physiques, comme la température ou la pression par exemple.

Les dispositifs SAW sont généralement réalisés par dépôt d'électrodes métalliques sous forme d'un réseau de peignes inter-digités sur un matériau piézoélectrique. Celui-ci consiste généralement en un substrat monocristallin tels que le quartz ($SiO_2$), le niobate de lithium ($LiNbO_3$), le tantalate de lithium ($LiTaO_3$) ou plus récemment la langasite ($La_3Ga_5SiO_{14}$). De façon plus marginale, ils peuvent également être réalisés sur des couches minces déposées par différentes voies, telles que le nitrure d'aluminium (AIN) ou l'oxyde de zinc (ZnO). Les substrats piézoélectriques monocristallins sont généralement disponibles sous forme de substrats (en anglais *wafers*) de 100 mm de diamètre (« 4 pouces ») orientés selon des angles particuliers pour optimiser les propriétés des ondes de surface. Pour le quartz les orientations les plus courantes sont les coupes AT, ST, SC, BT etc. Les coupes ainsi dénommées correspondent à des plans réticulaires définis par des rotations angulaires autour des axes X,Y,Z permettant de décrire l'état de la plaque par rapport à la norme IEEE Std-176, version 1949 (Std-176 IRE). Dans cette norme, la coupe AT correspond à une plaque dite YX (l'axe Y est orthogonal au plan de la plaque - colinéaire à son épaisseur - et l'axe X est défini suivant la longueur de la plaque) tournée de 36° autour de l'axe X. Elle est désignée par la nomenclature (YXl)/35,25°. La coupe ST correspond à la nomenclature (YXl)/42,75°, la coupe BT à (YXl)/-49°, quant à la coupe SC, elle procède de deux rotation successives, l'une de 21,9° autour de l'axe Z et la seconde de 34° autour de l'axe X selon la nomenclature (YXwl)/21,9°/34°. Chaque coupe correspond à des conditions de propagation élastique particulières qui impactent directement les caractéristiques des dispositifs.

En particulier, le choix d'un substrat et de son orientation cristalline pour réaliser un dispositif SAW est dicté par un certain nombre de critères, les deux suivants étant les principaux considérés pour les applications de filtrage :

- le coefficient de couplage électromécanique (0% < $k^2$ < 100%), qui représente l'efficacité de conversion de l'énergie électrique en énergie acoustique et inversement et qui caractérise la bande relative maximale que l'on sait réaliser pour des pertes données ;
- le coefficient de température de la fréquence (CTF exprimé en ppm/K), qui traduit la stabilité thermique du résonateur. Pour les applications de résonateurs pour source de fréquence,

sont également pris en compte :

- l'angle de flux d'énergie, qui représente l'écart entre la direction de propagation de l'onde de surface (vecteur d'onde) et la direction de propagation de l'énergie de cette onde (vecteur de Poynting) (William STEICHEN, Sylvain BALLANDRAS : Composants acoustiques utilisés pour le filtrage : Revue des différentes technologies, Techniques de l'ingénieur, E 2000 - 1-28), on le souhaite de préférence nul pour transmettre un maximum d'énergie de surface au transducteur de sortie et éviter ainsi le décalage des transducteurs pour rattraper cet angle de flux d'énergie et maximiser le fonctionnement des transducteurs mais cet écart est potentiellement compensable géométriquement ;
- le coefficient de réflexion sur « obstacle » unique de type électrode, sillon gravé ou toute structure élémentaire dont la période caractéristique correspond à la condition dite de Bragg, soit une demi-longueur d'onde qui conditionne l'efficacité des réseaux de Bragg pour le confinement de l'énergie acousto-électrique dans le plan, ce coefficient joue un rôle important dans l'optimisation du coefficient de qualité des résonateurs SAW ;
- la vitesse de propagation qui conditionne essentiellement les dimensions du résonateur et la capacité de fabrication à fréquence donnée ;
- la directivité du transducteur que l'on cherche à minimiser ou maximiser selon que l'on souhaite un mode pur ou un effet directionnel naturel (en particulier utile pour certains filtres).

Le tantalate de lithium et le niobate de lithium sont, en général, utilisés dans la fabrication de filtres SAW dans la gamme RadioFréquence (RF) de bandes relatives comprises entre 1 et 10% et pour lesquels un couplage électromécanique supérieur à 1% est souhaitable. Néanmoins, ces substrats souffrent d'une dérive en température trop importante pour une utilisation en tant que source de fréquence.

En revanche, le quartz présente une stabilité de la fréquence avec la température remarquable et un couplage électromécanique adapté pour les applications en bande étroite de type résonateur. Il est très couramment utilisé pour ce type d'applications et les oscillateurs stabilisés en fréquence par un résonateur à ondes élastiques de surface sur ce type de substrat présentent les meilleurs compromis bruit de phase/stabilité court terme/compacité pour les applications embarquées, et plus particulièrement pour la synthèse de fréquence pour la détection Radar. Toutefois, ces oscillateurs pourraient permettre d'atteindre des niveaux de détection supérieurs à ceux obtenus avec ceux de l'état de l'art en gagnant sur les coefficients de qualité aujourd'hui accessibles. A titre informatif, le produit coefficient de qualité - fréquence, noté Qf, maximum atteignable en SAW avec le quartz seul s'avère de l'ordre de $10^{13}$, ce qui correspond à un coefficient de qualité de 20 000 à 500 MHz.

Dans ce contexte, un substrat susceptible de fournir à la fois un couplage électromécanique adapté, des caractéristiques en température permettant un coefficient de température de la fréquence (CTF) proche de 0 ou permettant des températures d'inversion de la loi fréquence-température positives et un coefficient de qualité amélioré par rapport aux valeurs précédentes présente un intérêt certain pour améliorer les sources de fréquence et potentiellement étendre les applications des dispositifs SAW à de nouvelles opportunités.

Le brevet US 6933810 et la publication : « Temperature Compensated LiTaO3/Saphire Bonded SAW Substrate with Low Loss and High Coupling Factor Suitable for US-PCS Application » de M. Miura et al. publiée en 2004 dans les actes de l'IEEE Ultrasonics Symposium décrivent un substrat, pour des applications de type SAW, réalisé à partir d'un assemblage d'une couche de tantalate de lithium sur un substrat de saphir pouvant être défini comme un substrat hybride.

Il est également connu de la demande de brevet US 2010/0156241 de réaliser un empilement comprenant un premier matériau moncristallin en langasite et un second matériau en niobate de lithium ou en tantalate de lithium.

Néanmoins, ce type de dispositif n'est en aucun cas basé sur l'étude des modes de propagation des ondes élastiques dans un tel empilement et présente des inconvénients majeurs, à savoir :

- une limitation de la dilatation thermique du tantalate par collage sur un substrat de saphir, matériau à faible coefficient de dilatation thermique (TEC pour Thermal Expansion Coefficient) et à module d'Young élevé (matériau à rigidité élastique élevé), qui conduit à l'apparition de contraintes thermiques importantes sur une large surface du substrat hybride $LiTaO_3$/saphir ;
- des réflexions d'ondes de volume à l'interface de collage qui conduisent à la présence de réponses parasites sur les caractérisations en fréquence du résonateur SAW ;
- une forte dérive en température de la fréquence de résonance série (-15 ppm/K) et de résonance parallèle (-27 ppm/K) des résonateurs SAW utilisant ce type de substrat.

Il a également été proposé dans la publication : « High-Frequency Surface Acoustic Waves Excited on Thin-Oriented LiNbO3 Single-Crystal Layers Transferred Onto Silicon » de T. Pastureaud et al. publiée dans 2007 IEEE Transactions on Ultrasonics, une structure dans laquelle une couche piézoélectrique de niobate de lithium, à fort couplage, est reportée par implantation ionique/fracture sur un substrat de silicium présentant une vitesse acoustique élevée pour certains modes de propagation. Cette approche permet, notamment, de réaliser des filtres à large bande fonctionnant à des fréquences dépassant largement le GHz.

Cependant, une telle configuration présente également un certain nombre d'inconvénients comme par exemple :

- un très fort impact de la conductivité du substrat de silicium sur les caractéristiques (couplage électromécanique, pertes) du mode de cisaillement ;
- une limitation de l'exploitation des dispositifs réalisés ainsi, notamment à cause de la limite sur l'épaisseur maximale atteignable avec la technologie d'implantation/fracture employée ;
- une trop forte dérive en température de la fréquence de résonance (jusqu'à -50 ppm/K) des dispositifs réalisés pour une utilisation dans une application « source ».

Dans ce contexte, il apparaît donc difficile de trouver des matériaux piézoélectriques monocristallins offrant un compromis entre coefficient de qualité intrinsèque élevé (supérieur à celui du quartz, comparable à ceux du tantalate et niobate de lithium) et une stabilité de la fréquence avec la température. Par ailleurs, on observe très rarement des résonateurs sur matériaux à fort couplage électromécanique ($LiTaO_3$, $LiNbO_3$) présentant simultanément des coefficients de qualité record ($Qf \gg 10^{13}$).

Afin de résoudre les inconvénients précités, la présente invention a pour objet une solution permettant d'obtenir des dispositifs à ondes élastiques de surface excitées, guidées et détectées via un film piézoélectrique reporté sur un substrat de haute qualité acoustique permettant la propagation d'ondes élastiques sans pertes de propagation et minimisant les phénomènes d'absorption viscoélastique.

Plus précisément, l'invention a pour objet un dispositif à ondes élastiques de surface notamment pour résonateur ou filtre en particulier à bandes de transitions étroites de l'ordre de quelques %, comprenant un empilement comportant au moins :

- un film mince réalisé en un premier matériau piézoélectrique ;
- un substrat réalisé en un second matériau ;
- des moyens d'excitation pour générer au moins un mode de propagation d'ondes élastiques de surface au niveau dudit film piézoélectrique ;
   où
- le premier matériau est un matériau monocristallin et le second matériau est un matériau cristallin ;
- l'épaisseur du film mince de premier matériau piézoélectrique étant comprise entre 1 et 20 $\mu$m ;
- le premier matériau et le second matériau présentent des coefficients viscoélastiques inférieurs ou égaux à ceux du quartz pour le mode de propagation induit par les moyens d'excitation;
- le premier matériau est l'un des matériaux suivants : quartz, $GaPO_4$, $SiO_2$ dopé, ou langasite (LGS - $La_3Ga_5SiO_{14}$), langatate (LGT - $La_3Ga_{5,5}Ta_{0,5}O14$), langanite (LGN - $La_3Ga_{5,5}Nb_{0,5}O_{14}$), $Sr_3NbGa_3Si_2O_{14}$ (SNGS), $Ca_3NbGa_3Si_2O_{14}$ (CNGS), $Ca_3TaGa_3Si_2O_{14}$ (CTGS), $Sr_3TaGa_3Si_2O_{14}$ (STGS), $Ca_3TaAl_3Si_2O_{14}$ (CTAS);
- le second matériau est l'un des matériaux suivants : saphir, niobate de lithium, ou tantalate de lithium.

On définit dans la présente invention, l'ensemble film mince en premier matériau piézoélectrique sur substrat en second matériau comme un substrat hybride.

Dans le cadre de dispositif à ondes élastiques de surface et plus particulièrement dans le cadre des résonateurs à ondes élastiques de surface, si l'on veut bénéficier de la contribution du substrat dans l'amélioration des spécificités du composant/résonateur (augmenter le facteur de qualité, augmenter le coefficient de couplage, minimiser les effets de température, etc.), il est fondamental que la couche piézoélectrique supérieure soit suffisamment mince pour permettre un couplage des propriétés de cette même couche avec le substrat. Au-delà de 20pm, le Demandeur a réalisé des simulations montrant que la contribution du substrat est négligeable, le gain en performances sur le résonateur est quasi nul par rapport à une structure monobloc ne présentant que le matériau composant la couche mince.

Avantageusement, l'épaisseur du film mince de premier matériau piézoélectrique est inférieure ou égale à 5 lambdas $\lambda$, lambda étant la longueur d'ondes acoustiques, pour les ondes de cisaillement transverses majoritaires afin de garantir une distribution d'énergie entre film mince et substrat permettant de tirer parti des propriétés remarquables des deux matériaux ainsi associés.

Cette épaisseur peut être même ramenée à 2 lambdas pour les ondes de polarisation majoritairement elliptiques (assimilées aux ondes de Rayleigh).

Selon une variante de l'invention, le second matériau est un matériau monocristallin.

Selon des variantes de l'invention, le film de premier matériau monocristallin est en contact direct avec le substrat réalisé dans le second matériau.

Un contact direct permet un continuum à l'échelle atomique qui favorise une interaction purement élastique à l'interface. Il en résulte un assemblage de matériaux composites qui constitue un médium dans lequel les ondes élastiques peuvent se propager sans pertes énergétiques.

Le contact direct présente ainsi des avantages par rapport à un contact via des matériaux organiques. En effet, la présence de matériaux organiques sur le passage de l'onde induit des effets de conversion acousto-thermique des ondes élastiques du fait des propriétés de viscosité (la plupart des matériaux organiques présentent des coefficients de visco-élasticité tg(delta) caractérisés par le rapport des parties imaginaire G" et réelle G' de leur constante de cisaillement noté G=G'+jG" inférieurs ou égaux à 100 sur toute la gamme des très hautes et ultra hautes fréquences (VHF-UHF). Cette constante est inversement proportionnelle à la capacité du film à convertir l'énergie élastique en énergie thermique.

Les coefficients équivalents de matériaux monocristallins, en particulier ceux du quartz, correspondent à des valeurs évoluant de 10 000 000 à 1 000 selon les fréquences croissantes de 1MHz à 10 GHz. L'effet de la conversion d'énergie induite par la présence par exemple de polymère sur le parcours de l'onde se traduit immédiatement par une réduction significative (qui peut atteindre un à plusieurs ordres de grandeur en fonction du volume de matériau traversé par l'onde) du coefficient de qualité d'un résonateur fondé sur un assemblage de matériau tel que proposé dans l'invention.

Selon des variantes de l'invention, le dispositif à ondes élastiques de surface peut également comprendre au moins un film inorganique entre le film de premier matériau monocristallin et le substrat de second matériau.

Il peut comprendre un premier film inorganique intermédiaire entre le substrat et le film piézoélectrique, assurant le collage dudit film sur ledit substrat.

Il peut également comprendre un second film intermédiaire en matériau métallique, situé entre le substrat et le film piézoélectrique, dont l'épaisseur et la nature du film permettent d'ajuster le coefficient de température de la fréquence du mode de propagation

De manière générale, les matériaux organiques présentent de propriétés acoustiques moins favorables (systématiquement plus de pertes et d'atténuation) que les matériaux inorganiques solides. Les matériaux organiques se dégradent plus rapidement dans le temps (fatigue, dégradation structurelle des liaisons organiques).

De plus la mise en oeuvre de couches ultraminces (épaisseur inférieure à environ 10 $\mu$m, avec une uniformité d'épaisseur TTV (total thickness variation) inférieure à 500nm), de matériaux adhésifs organiques est difficile, alors que la maîtrise des épaisseurs est primordiale :

- pour bénéficier du couplage couche mince piézo /substrat il ne faut pas que les couches intermédiaires soient trop épaisses, typiquement ne pas être supérieures à 10$\mu$m ;
- pour limiter les effets de dispersion modale qui nuisent à la maîtrise des fréquences et globalement à la réponse électrique du dispositif.

L'uniformité de l'empilement doit être maîtrisée garantissant une propagation de l'onde sans pertes ni déformation de l'onde acoustique.

Le collage moléculaire direct de diélectriques inorganiques et le collage direct métallique aboutissent par des mécanismes différents (évolution de liaisons hydrophiles ou mécanismes diffusifs) à la formation de liaisons covalentes beaucoup plus fortes que des liaisons organiques sur des épaisseurs notablement inférieures à 1 $\mu$m (très inférieures à la longueur d'onde acoustique). De plus, les méthodes de dépôts (PVD, CVD etc.) permettent une maîtrise quasi parfaite (au nanomètre) des épaisseurs de ces mêmes couches.

Le substrat peut être lui-même sur un support quelconque.

Selon une variante de l'invention, le dispositif comprend un premier film intermédiaire entre le substrat et le film piézoélectrique, assurant le collage dudit film sur ledit substrat.

Selon une variante de l'invention, le dispositif comporte un second film intermédiaire en matériau métallique, situé entre le substrat et le film piézoélectrique, dont la nature du film et surtout l'épaisseur permettent d'ajuster le coefficient de température de la fréquence du mode de propagation.

Selon une variante de l'invention, quand le second matériau est du saphir, avantageusement, son orientation cristalline peut être de type C-plane, ou R-plane, ou M-plane ou A-plane.

Le type C correspond à une plaque avec l'axe Z ou axe optique C normal à la surface défini aussi avec les indices de Miller (001) définie comme une coupe (ZX) ou (YXl)/90° en norme IEEE Std-176, le type R à une coupe Y tournée de 33° autour de l'axe X correspondant aux indices (102) notée (YXl)/33° selon le standard Std-176 IEEE), le type M à une plaque de coupe (YX) correspondant aux indices (010) noté (YX) en Std-176, le type A correspond à une orientation (120).

Selon une variante de l'invention, le substrat de niobate de lithium présente une coupe choisie parmi les suivantes : coupe (YX), coupe (YXl)/+ 41°, coupe (YXl)/ + 64°, coupe (YXl)/ + 128° avec une tolérance de $\pm$5° autour de ces orientations cristallines, défini selon la norme IEEE Std-176.

Selon une variante de l'invention, le substrat de tantalate de lithium présente une coupe choisie parmi les suivantes : coupe (XY), coupe (YXl)/ + 36°, coupe (YXl)/ + 42°, coupe (YXl)/+ $\theta$ avec $\theta$ compris entre 30° et 50°.

Selon une variante de l'invention, le film mince a une épaisseur comprise entre environ 1 $\mu$m et environ 20 $\mu$m.

L'invention a aussi pour objet un filtre ou un résonateur comprenant un dispositif selon l'invention.

L'invention a encore pour objet un procédé de fabrication d'un dispositif à ondes élastiques selon l'invention, caractérisé en ce qu'il comprend :

- le transfert d'un premier substrat comprenant ledit premier matériau piézoélectrique sur un second substrat comprenant ledit second matériau ;
- une opération d'amincissement dudit premier substrat pour définir le film de premier matériau piézoélectrique ;
- la réalisation de moyens d'excitation dudit premier matériau piézoélectrique sur ledit film de premier matériau.

Selon une variante de l'invention, l'étape de transfert comporte une étape de collage par collage hydrophile direct par l'intermédiaire d'une couche diélectrique pouvant être en SiO$_2$ déposée sur le premier et/ou le second substrat(s).

Selon une variante de l'invention, l'étape de transfert comporte une étape de collage par collage hydrophile direct ou par collage assisté par thermocompression, par l'intermédiaire d'une couche métallique, pouvant être de l'or, déposée sur le premier et/ou le second substrat(s).

L'invention sera mieux comprise et d'autres avantages apparaîtront à la lecture de la description qui va suivre donnée à titre non limitatif et grâce aux figures annexées parmi lesquelles :

- les figures 1a et 1b illustrent les angles de coupe définis selon la norme IEEE 49 (Std-176 révision 1949) et la direction de propagation d'ondes élastiques ;
- les figures 2a à 2f illustrent les étapes de procédé de réalisation selon l'invention d'un dispositif SAW sur un substrat hybride obtenu par collage/amincissement selon l'art connu ;

- la figure 3 schématise un empilement constitutif d'un dispositif SAW selon l'invention ;
- la figure 4 illustre la dispersion du mode de cisaillement (ondes STW) dans le cas d'une couche mince de quartz *(YXlt)*/37°±5°/90°±2° (en notation IEEE std-176 révision 1949) sur substrat de saphir (C-plane) en fonction du produit (fréquence).(épaisseur de quartz) exprimé en GHz.$\mu$m (équivalent à des km.s$^{-1}$) ;
- la figure 5 illustre l'évolution du couplage $K^2$ (%) et du coefficient $CTF_1$ (ppm/K) en fonction de l'épaisseur de quartz ($\mu$m) dans le cas d'une couche mince de quartz *(YXlt)*/37°±5°/90°±2° (en notation IEEE Std-176 révision 1949) sur substrat de saphir (C-plane) en fonction de l'épaisseur de film de quartz ($\mu$m) ;
- la figure 6 illustre l'évolution du couplage $K^2$ (%) et des pertes (dB/$\lambda$) en fonction de l'épaisseur de quartz ($\mu$m) dans le cas d'une couche mince de quartz (YXlt)/37°±5°/90°±2° (en notation IEEE std-176 révision 1949) sur substrat de saphir (C-plane) ;
- la figure 7 illustre la dispersion du mode de cisaillement (ondes STW) dans le cas d'une couche mince de quartz (YX*lt*)/37°±5°/90°±2° (en notation IEEE std-176 révision 1949) sur substrat de saphir (C-plane) comprenant une couche de SiO$_2$ à l'interface quartz/saphir de 200 nm d'épaisseur ;
- la figure 8 illustre l'évolution du coefficient de couplage $K^2$ (%) et du coefficient $CTF_1$ (ppm/K) en fonction de l'épaisseur de quartz ($\mu$m) dans le cas d'une couche mince de quartz (YX*lt*0)/37°±5°/90°±2° (en notation IEEE std-176 révision 1949) sur substrat de saphir (C-plane) comprenant une couche de SiO$_2$ à l'interface quartz/saphir de 200 nm d'épaisseur ;
- la figure 9 illustre la dispersion du mode de cisaillement (ondes STW) dans le cas d'une couche mince de quartz (YX*lt*)/37°±5°/90°±2° (en notation IEEE std-176 révision 1949) sur substrat de saphir (C-plane) comprenant une couche d'or à l'interface quartz/saphir de 200 nm d'épaisseur ;
- la figure 10 illustre l'évolution du couplage $K^2$ (%) et du coefficient $CTF_1$ (ppm/K) en fonction de l'épaisseur de quartz ($\mu$m) dans le cas d'une couche mince de quartz (YX*lt*)/37°±5°/90°±2° (en notation IEEE std-176 révision 1949) sur substrat de saphir (C-plane) comprenant une couche d'or à l'interface quartz/saphir de 200 nm d'épaisseur.

De manière générale, la présente invention a pour objet un dispositif à ondes de surface présentant un empilement innovant pour la réalisation d'un substrat dit « hybride » permettant la réalisation de dispositifs en technologie SAW sur ledit substrat hybride, comprenant au moins deux éléments : un film piézoélectrique et un substrat à haute qualité acoustique.

Ce type de substrat hybride permet de fonctionner à des fréquences comprises entre la centaine de MHz et quelques GHz sans difficultés de réalisation majeures et peut être optimisé pour une application particulière en cherchant à maximiser les coefficients de qualité, favoriser un coefficient de couplage compris entre 0,1 et 1% et présentant une insensibilité effective aux effets de température (i.e. permettant une compensation des effets thermoélastiques au sein du dispositif à la température de travail souhaité, celle-ci pouvant se trouver classiquement dans la gamme 20/120°C).

Les dispositifs en technologie SAW, ainsi réalisés sur un tel substrat hybride, peuvent avantageusement être de type résonateur. Le choix judicieux de la configuration angulaire, de la polarisation de l'onde et de la métallisation permet par ailleurs d'accéder à des structures de tailles réduites par rapport aux solutions de l'état de l'art.

Le matériau du film piézoélectrique peut avantageusement être du quartz compte-tenu de l'existence d'orientations cristallines compensées des effets de température pour les ondes de Rayleigh et de cisaillement de surface (STW) ou présentant une dérive thermique légèrement positive pour ces types d'ondes (typiquement comprise entre 0 et 10 ppm.K$^{-1}$).

Le substrat peut avantageusement être constitué de saphir monocristallin en raison des faibles pertes viscoélastiques de ce type de substrat qui conduisent généralement à l'obtention de très forts coefficients de qualité ($Qf \approx 10^{14}$).

Les ondes élastiques de surface sont excitées et détectées sur le film piézoélectrique grâce à des transducteurs à peignes inter-digités (IDT pour *InterDigitated Transducer*), réalisés en surface supérieure de la structure par les technologies classiques de photolithographie, de dépôt et d'usinage (de type lift-off par exemple) de couches métalliques (généralement en aluminium).

Il est à noter que des caractéristiques avantageuses des résonateurs peuvent être obtenues sur ce type de substrat, pour une certaine gamme d'épaisseurs et pour une gamme d'orientations cristallines spécifiques du film piézoélectrique en quartz. De manière similaire, le substrat de saphir est également choisi avec une orientation cristalline particulière.

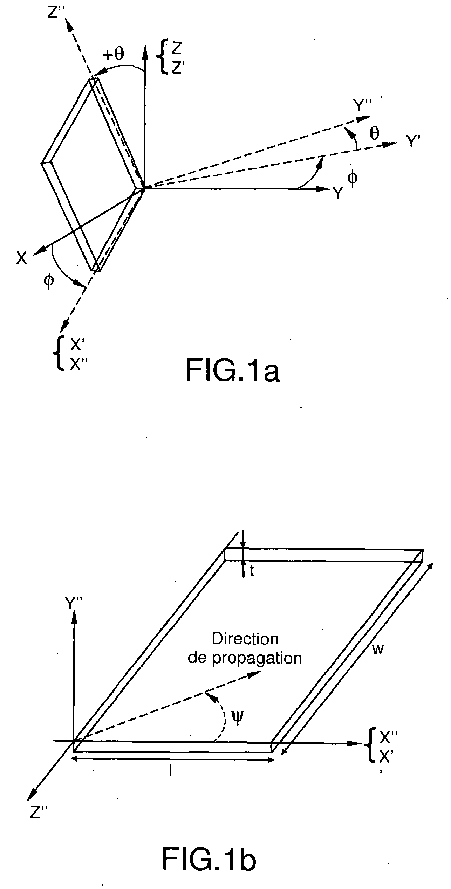

Les coupes cristallines sont définies dans la présente invention selon la norme IEEE 49 (Std-176, révision 1949, en particulier pour une définition cohérente des signes des angles de rotation du quartz par rapport à la pratique en vigueur pour l'homme de l'art). Plus précisément, une coupe cristalline est définie par deux angles de rotation. L'angle $\Phi$ définit la rotation autour de l'axe optique Z et l'angle $\theta$ la rotation autour de l'axe X. Les figures 1a et 1b illustrent comment sont définis ces angles dans les normes IEEE 1949.

Pour les ondes de surface, un troisième angle définit la direction de propagation de l'onde, l'angle noté $\psi$, autour de l'axe normal à celle-ci, noté Y'' (l'axe Y initial ayant subit les deux rotations précédentes $\Phi$ et $\theta$).

On appelle par ailleurs :

- coupe à simple rotation toute coupe telle que Φ=0 et θ≠0
- coupe à double rotation toute coupe telle que Φ≠0 et θ≠0

Une coupe est définie dans le standard IEEE Std-176 par les axes portés par l'épaisseur et la longueur de la plaque (exemple figure 1a, coupe YX) et les angles de rotation autour des axes portant la largeur (w), la longueur (l) et l'épaisseur de la plaque (t), w comme « width » représente la largeur de la plaque et désigne l'axe Z, l comme « length » l'axe X et bien entendu t l'axe Y, ces axes étant entendu par principe après rotation, c'est-à-dire que pour une coupe à trois rotations on effectue d'abord la rotation Φ autour de l'axe Z (w) puis la rotation θ selon l'axe X tourné noté X' (l) et enfin la rotation ψ autour de l'axe Y tourné noté Y" (t) qui aura donc subit les deux premières rotations.

De manière générale, les combinaisons de matériaux à faibles pertes viscoélastiques peuvent être recensés de façon exhaustive (saphir, carbure de silicium SiC, silicium dit fusion zone FZ, carbone diamant monocristallin ou nano-cristallin, wafers de type grenats - grenat d'ytrium et d'aluminium YAG, grenat d'ytrium et de fer YIG, etc. - niobate et tantalate de lithium), les coupes de ces matériaux étant choisies de sorte que la vitesse de phase des ondes se propageant à leur surface dépasse celle des ondes se propageant sur les coupes de quartz énumérées plus haut, soit au minimum 3300 m.s$^{-1}$ pour les ondes de Rayleigh et 5100 m.s$^{-1}$ pour les ondes de surface transversales (STW).

Dans la présente invention, un matériau est considéré à faibles pertes viscoélastiques de manière relative et ce lorsque ses constantes viscoélastiques sont inférieures ou égales à celles du quartz indiquées ci-dessous.

Tableau 1.1 - Coefficients de frottements de viscoélasticité du quartz

|  | $\eta_{11}$ | $\eta_{33}$ | $\eta_{12}$ | $\eta_{13}$ | $\eta_{44}$ | $\eta_{66}$ | $\eta_{14}$ |
|---|---|---|---|---|---|---|---|
| **Quartz** | 1,37(0) | 0,96(9) | 0,73(0) | 0,71(5) | 0,36(4) | 0,302 | 0,01(2) |

Les chiffres entre parenthèses représentent la décimale pour laquelle l'incertitude de mesure ne permet pas de figer la valeur de façon définitive, elle est donnée à titre indicatif et permet de se fixer une idée sur le degré de précision de ces constantes.

Ce tableau renseigne les coefficients de frottement viscoélastique équivalent (frottements viscoélastiques au sens de la modélisation standard de la mécanique des milieux continus, il s'agit d'une analogie avec l'acoustique dans les fluides pour laquelle on parle de viscosité absolue) pour le quartz ($\eta_{ij}$ en Ns/m$^2$) mesurés à 450 MHz en ondes de volume.

Les données proviennent de Lamb & Richter : J. Lamb and J. Richter, "Anisotropic Acoustic Attenuation With New Measurements for Quartz at Room Temperature," Proc. R. Soc. London, Ser. A293, pp. 479-492, 1966, pour le quartz, les indices du Tableau 1.1 étant des indices contractés par rapport à ceux du Tableau 3 du document de Lamb & Richter.

Ces constantes donnent lieu à un produit coefficient de qualité par fréquence Qf de 10$^{13}$ max pour les ondes de Rayleigh :T.E. Parker, J. A Greer, "SAW oscillators with Low Vibration Sensitivity", Proc. of the 45th ASFC, 1991, pp.321-329 et D. Andres, T. E. Parker, "Designing smaller SAW oscillators for low vibration sensitivity", Proc. of the IEEE IFCS, 1994, pp.352-358 et de 1,5 x 10$^{13}$ max pour les ondes de cisaillement guidées en surface du quartz: Avramov, I.D., "Low voltage, high performance, GHz range STW clocks with BAW crystal stability," Frequency Control Symposium and Exposition, 2005. Proceedings of the 2005 IEEE International, vol., no., pp.880,885, 29-31 Aug. 2005, doi: 10.1109/FREQ.2005.1574049.

Concernant les orientations du saphir, les orientations d'intérêt peuvent être de type C-plane, R-plane, M-plane et A-plane.

Parmi les orientations d'intérêt du niobate de lithium (LiNbO$_3$) et du tantalate de lithium (LiTaO$_3$), on peut mentionner les coupes suivantes :

| Cristal | Coupe | - | Propagation |
|---|---|---|---|
| **LiNbO$_3$** | *Y* | - | *Z* |
|  | *Y+41°* | - | *X* |
|  | *Y+64°* | - | *X* |
|  | *Y + 128°* | - | *X* |

(suite)

| Cristal | Coupe | - | Propagation |
|---------|-------|---|-------------|
| LiTaO$_3$ | *X* | - | *Y + 112°* |
| | *Y + 36°* | - | *X* |
| | *Y + 42°* | - | *X* |
| | *Y + θ (30° < θ < 50°)* - | | *X* |

Les ondes elliptiques (type ondes de Rayleigh) et de cisaillement doivent être prises en compte et une modalité de prévision de l'épaisseur de quartz et de son orientation cristalline pour un coefficient CTF donné, doit être ajoutée.

Le quartz peut être remplacé par un de ses isomorphes (GaPO$_4$, SiO$_2$ dopé, etc.) ou par un matériau de même classe cristalline (langasite (LGS - La$_3$Ga$_5$SiO$_{14}$), langatate (LGT - La$_3$Ga$_{5,5}$Ta$_{0,5}$O$_{14}$), langanite (LGN - La$_3$Ga$_{5,5}$Nb$_{0,5}$O$_{14}$), et de façon générale tout matériau de cette même famille sans omettre les nouveaux matériaux complexes proposés récemment par FOMOS comme Sr$_3$NbGa$_3$Si$_2$O$_{14}$ (SNGS), Ca$_3$NbGa$_3$Si$_2$O$_{14}$ (CNGS), Ca$_3$TaGa$_3$Si$_2$O$_{14}$ (CTGS), Sr$_3$TaGa$_3$Si$_2$O$_{14}$ (STGS) et Ca$_3$TaAl$_3$Si$_2$O$_{14}$ (CTAS)).

La structure de ce substrat hybride peut être optimisée pour augmenter le facteur de qualité et le coefficient de couplage du résonateur tout en minimisant voire compensant les effets de température sur la fréquence propre du résonateur par simulation numérique en faisant varier les différents paramètres notamment la nature des matériaux, l'orientation cristallines de ces matériaux, l'épaisseur du film de premier matériau.

De manière générale, le dispositif de la présente invention consiste ainsi en l'empilement de deux matériaux cristallins, dont l'un au moins est monocristallin, nécessitant des procédés de fabrication adaptés pour réaliser le substrat hybride.

Avantageusement, les procédés retenus utilisent la technique de report par collage/amincissement permettant de conserver le caractère monocristallin d'un substrat initial choisi.

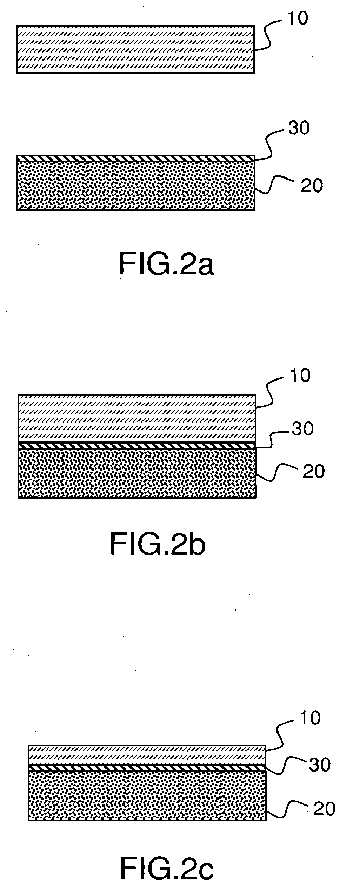

Les principales étapes de ce type de procédé sont illustrées grâce aux figures 2a à 2f.

Une première étape illustrée en figure 2a, met en évidence l'utilisation de deux substrats : un premier substrat 10 en un premier matériau piézoélectrique monocristallin et un second substrat 20 en un second matériau cristallin recouvert d'une couche de collage 30, avec préparation des surfaces destinées à être en regard.

Selon une seconde étape, illustrée en figure 2b, on procède au collage direct des deux substrats, via la couche de collage 30.

Selon une troisième étape illustré en figure 2c, on réalise une étape d'amincissement du substrat monocristallin piézoélectrique 10, pour définir un film mince monocristallin piézoélectrique dont l'épaisseur est comprise entre 1 et 20 μm en fonction de la fréquence de travail (entre 100 MHz et 3 GHz) et des points de fonctionnement visés en termes de coefficients de couplage électromécanique et de température de la fréquence - CTF, par une opération de rodage mécanique, suivie d'une étape de polissage.

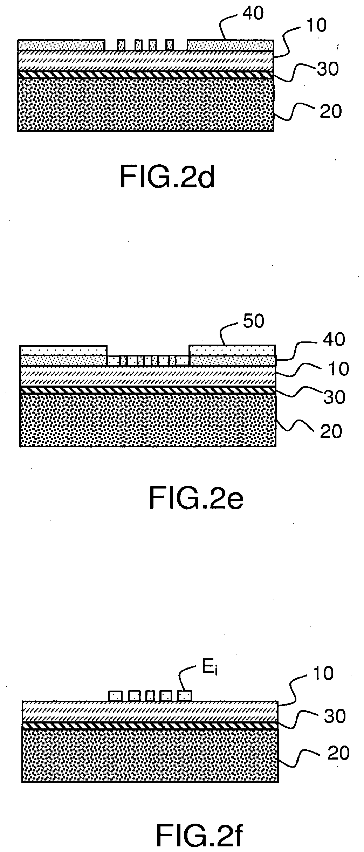

Selon une quatrième étape illustrée en figure 2d, on procède au dépôt d'une couche de résine 40, à son insolation puis à son développement afin de définir un masque de résine.

Selon une cinquième étape illustré en figure 2e, on procède au dépôt d'une couche métallique 50, destinée à la réalisation des moyens d'excitation sous forme d'électrodes.

Selon une sixième étape illustré en figure 2f, on procède au retrait du masque de résine, permettant d'obtenir des électrodes Ei à la surface du film de matériau piézoélectrique monocristallin, à la surface du substrat cristallin.

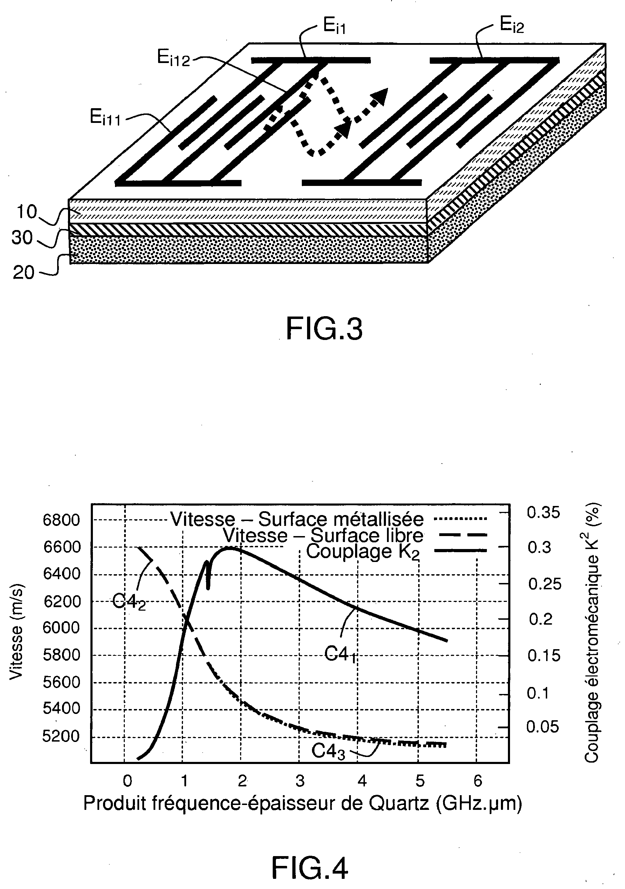

La figure 3 illustre un exemple de configuration d'électrodes réalisées à la surface du substrat hybride, mettant en évidence deux jeux d'électrodes interdigitées Ei$_1$ et Ei$_2$ (par exemple le premier jeu d'électrodes comprend un peigne d'électrodes Ei$_{11}$ et un peigne d'électrodes Ei$_{12}$ interdigités).

La technologie par collage/amincissement permet d'accéder sans difficultés à la gamme d'épaisseur de quartz pouvant être ciblée dans la présente invention (1 μm < épaisseur < 20 μm).

Une description plus détaillée de l'approche par collage/amincissement est décrite dans la publication de Grousset, S.; Augendre, E.; Benaissa, L.; Signamarcheix, T.; Baron, T.; Courjon, E.; Ballandras, S., "SAW pressure sensor based on single-crystal quartz layer transferred on Silicon," European Frequency and Time Forum & International Frequency Control Symposium (EFTF/IFC), 2013 Joint, vol., no., pp.980,983, 21-25 July 201.

De manière pratique, il est possible de transférer le substrat de quartz sur le substrat hôte en saphir par l'intermédiaire d'une couche d'oxyde de silicium, SiO$_2$ d'environ 100 nm, située à l'interface de collage. Cette variante est réalisée par collage hydrophile direct.

Il est aussi possible de transférer le substrat de quartz sur le substrat hôte en saphir par l'intermédiaire d'une couche d'or d'épaisseur comprise entre 40 nm et 500 nm par collage métallique (direct ou assisté par thermo-compression).

Le procédé décrit ci-dessus permet ainsi de définir l'empilement suivant :

- une couche piézoélectrique de quartz obtenue par amincissement mécanique et polissage mécano-chimique du substrat massif monocristallin de quartz ;
- une couche de collage compatible avec le collage direct ou le collage métallique ;
- un substrat réalisé dans un matériau à haute qualité acoustique est compris dans l'ensemble des matériaux que sont le saphir, LiNbO$_3$, LiTaO$_3$, YAG..., réputés pour leurs coefficients viscoélastiques 5 à dix fois inférieurs à ceux du quartz (cf. Tableau 1.1)

Avantageusement, la structure peut être composée d'une couche de collage de type SiO$_2$ ou d'or ne modifiant que très peu les caractéristiques des courbes de dispersion obtenues. L'épaisseur de collage est préférablement inférieure à un dixième de la longueur d'onde. Dans le cas du collage métallique, une couche de passivation peut être avantageusement déposée sur le wafer à amincir côté collage afin de minimiser l'impact de la couche d'or sur les propriétés finales de l'empilement.

Il est à noter que cette épaisseur peut être négligée dans des opérations de simulations (telles que celles décrites ci-après) quand elle est inférieure à un centième de la longueur d'onde. Elle est prise en compte pour corriger sensiblement les épaisseurs optimales dans le cas contraire.

Pour rappel, la longueur d'onde est égale au rapport de la vitesse de l'onde élastique sur la fréquence de cette onde :

$$\lambda = \frac{v}{f}$$

Afin d'optimiser le coefficient de couplage électromécanique et de réduire les pertes liées à la propagation des ondes élastiques, l'invention repose ainsi sur l'utilisation de guides d'ondes élastiques par la réalisation d'un substrat hybride.

Les Demandeurs ont réalisé des simulations sur différents substrats hybride d'intérêt pour la présente invention.

Premier exemple de substrat hybride :

Le substrat est constitué d'un film mince piézoélectrique de quartz sur un substrat monocristallin en saphir de plusieurs dizaines de longueurs d'onde acoustique (supérieur à 30 longueurs d'onde idéalement pour les ondes de surface transversales STW, à 15 longueurs d'onde pour les ondes de polarisation elliptique).

Dans le cas où le mode de propagation des ondes élastiques de surface générées dans l'assemblage film/substrat intervient à des vitesses inférieures aux ondes de volume (de même polarisation) du substrat seul, l'énergie ne pouvant être rayonnée vers le coeur de la structure est guidée par le substrat dans le film mince.

Pour une onde à polarisation elliptique, on parle d'onde inhomogène pour décrire l'atténuation exponentielle modulée par une fonction sinusoïdale de l'onde dans le substrat, alors qu'il est question d'onde évanescente pour les ondes de cisaillement. Dans le premier cas, l'onde est considérée quasiment atténuée au bout de deux longueurs d'onde alors que la pénétration des ondes de cisaillement peut s'étendre sur plusieurs longueurs d'ondes. Dans les deux cas, on obtient dans ces conditions des ondes se propageant sans pertes de rayonnement dans le film piézoélectrique et l'on parle bien d'ondes élastiques guidées.

La figure 4 représente les résultats de simulations numériques du comportement d'ondes de surface transversales STW pour une structure composée d'un film de quartz reporté sur un substrat de saphir.

On peut remarquer que pour des produits fréquence-épaisseur supérieurs à 2,5 GHz.$\mu$m, le mode est de moins en moins sensible à la présence du substrat et se comporte comme sur un quartz considéré semi-infini. La courbe C4$_1$ est relative au coefficient de couplage électromécanique K$^2$, la courbe C4$_2$ est relative à la vitesse de propagation pour une surface dite libre, c'est-à-dire sans dépôt d'électrode ni d'aucun élément pouvant entraver la propagation, la courbe C4$_3$ est relative à la vitesse de propagation pour une surface entièrement métallisée (sans tenir compte de l'effet de masse induit par une telle métallisation).

A l'inverse, pour des fréquences-épaisseurs du film inférieures à 2,5 GHz.$\mu$m, le mode est très sensible à la présence du substrat de saphir. En particulier, on voit apparaître un maximum de couplage électromécanique K$^2$ de 0,3% correspondant à un produit fréquence-épaisseur de Quartz d'environ 2 GHz.$\mu$m.

En pratique, pour un résonateur SAW fonctionnant à 500 MHz cela équivaut à une épaisseur de quartz optimale de 4$\mu$m.

Cette particularité permet notamment d'optimiser la fréquence d'utilisation du dispositif ainsi que l'épaisseur du film de quartz afin d'améliorer le couplage électromécanique par rapport à celui de la couche ou du substrat pris individuellement (dans le cas où le substrat serait piézoélectrique).

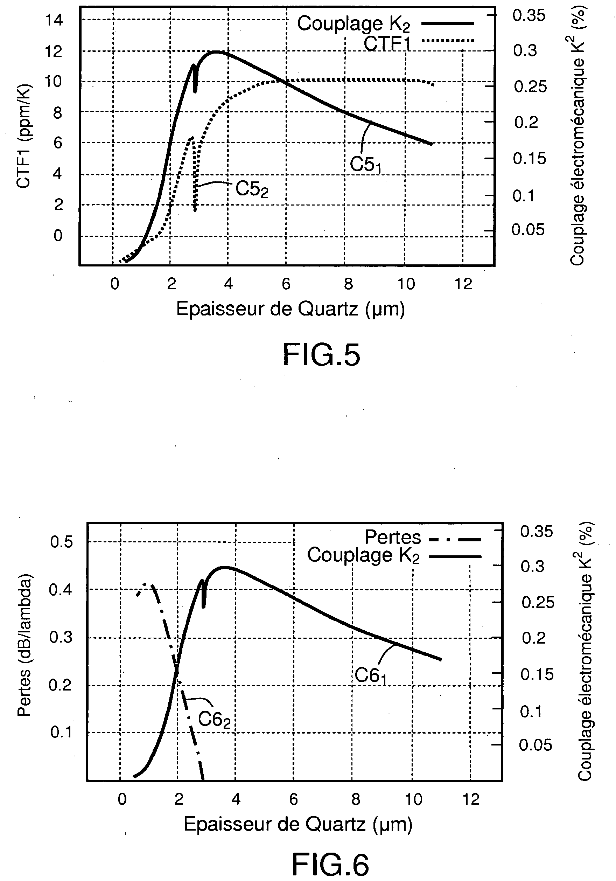

La figure 5 représente le couplage K$^2$ du mode de cisaillement (courbe C5$_1$) ainsi que le coefficient de température de la fréquence (au 1er ordre) (courbe C5$_2$) en fonction de l'épaisseur de quartz dans l'empilement. Ces résultats montrent que pour une épaisseur de quartz de 4 $\mu$m, correspondant au maximum de couplage pouvant être obtenu, on obtient une sensibilité à la température relativement faible (9 ppm/K), proche de la compensation en température mais surtout permettant une température d'inversion de la loi fréquence-température supérieure à 25°C, paramètre-clé pour les applications « sources » pour lesquelles l'oscillateur est souvent thermostaté à des températures dépassant sa gamme thermique opératoire (-40/+85°C). De manière remarquable, on voit apparaître un palier du CTF$_1$ à 10 ppm/K pour des épaisseurs de quartz pouvant atteindre jusqu'à 11 $\mu$m tout en conservant un couplage K$^2$ suffisant pour les applications visées, de type résonateur.

Enfin, la figure 6 représente l'évolution du couplage K$^2$ du mode de cisaillement (courbe C6$_1$) ainsi que les pertes de propagation, exprimées en dB/$\lambda$ (Courbe C6$_2$). On vérifie ainsi que pour l'épaisseur optimale (4 $\mu$m) du film de quartz correspondant au maximum de couplage ainsi que pour des épaisseurs plus importantes comprises entre 3 $\mu$m et 11 $\mu$m correspondant au palier du CTF$_1$ observé, les pertes de propagation du mode de cisaillement choisi sont négligeables (nettement inférieures à 10$^{-3}$ dB/$\lambda$). On note que le décrochement observé sur toutes les courbes représentées correspond à la vitesse de propagation du mode égale à celle de l'onde de volume lente rayonnée par la surface, appelée encore onde SSBW. Au-delà de cette vitesse (de l'ordre de 5800 m.s$^{-1}$ pour le saphir), le substrat ne guide plus l'onde dans la couche piézoélectrique.

Les empilements innovants, constitutifs de ce substrat hybride, sont réalisés par collage direct du substrat piézoélectrique sur le substrat de haute qualité acoustique. Par la suite, l'épaisseur finale de 4 $\mu$m (ou la gamme d'épaisseur comprise entre 3 et 11 $\mu$m) du film de Quartz est atteinte par amincissement mécanique puis polissage mécano-chimique.

Les résonateurs à ondes de surface simple-port, pouvant être réalisés sur ce type de substrat, sont constitués d'une zone de transduction centrale (à peignes inter-digités) faisant office de cavité résonnante et entourée par deux réflecteurs (miroirs). Le transducteur est constitué d'une alternance d'électrodes, qui se répètent avec une certaine périodicité, appelée période de métallisation, déposées sur le substrat hybride. Les électrodes avantageusement en aluminium (pouvant être réalisées par photolithographie et technique dite de « lift-off ») ont une épaisseur pouvant aller de quelques centaines d'angströms typiquement jusqu'au micron.

Ainsi, le choix des matériaux, leurs associations, leurs orientations cristallines, et l'épaisseur de couche offrent un large éventail de possibilités pour optimiser le coefficient de couplage et la sensibilité en température des modes de propagation adaptés à certains types d'applications.

Second exemple de substrat hybride :

Dans une variante de l'invention, la structure du substrat hybride peut comprendre une couche de silice (SiO$_2$) ou une couche d'or à l'interface entre le film piézoélectrique de quartz et le substrat de haute qualité acoustique en saphir.

En effet, afin de faciliter le report et dans un objectif d'intégration monolithique du film de quartz sur le substrat de saphir, il peut être nécessaire d'envisager l'utilisation d'une couche de collage de type SiO$_2$ ou de type or. Cette couche peut être déposée avantageusement, avant collage, sur le substrat piézoélectrique ou sur le substrat de haute qualité acoustique ou bien sur les deux substrats.

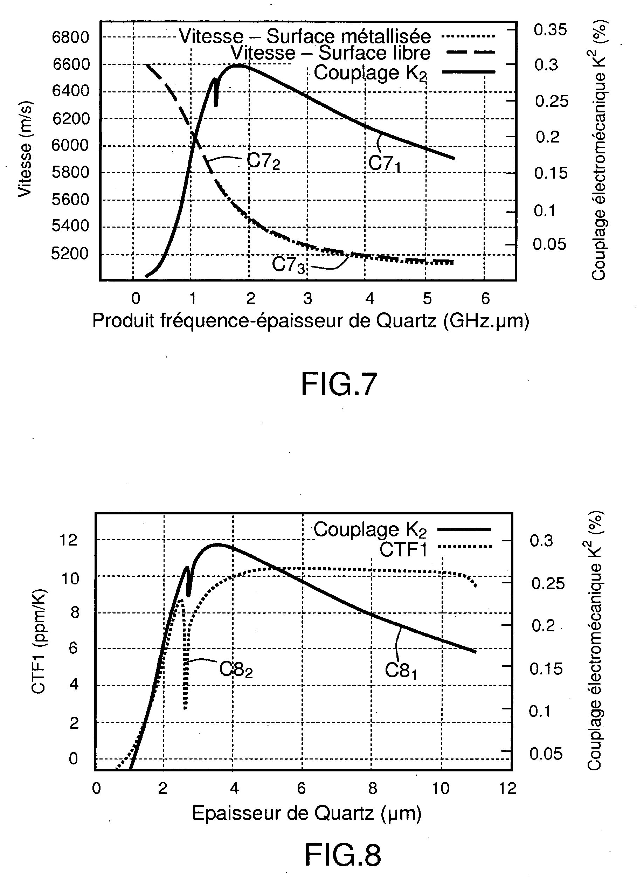

Dans le cas de l'utilisation d'une couche de SiO$_2$, les deux substrats sont assemblés par collage direct à température ambiante et pression atmosphérique. Le collage est rendu possible par une préparation de surface adéquate (nettoyage chimique, polissage mécano-chimique, activation plasma) permettant le collage direct. On peut remarquer, d'après les figures 7 et 8, que les caractéristiques du mode de cisaillement ne sont quasiment pas influencées par la présence d'une couche de SiO$_2$ d'environ 200 nm entre le film piézoélectrique de quartz et le substrat de saphir.

La courbe C7$_1$ est relative à l'évolution du coefficient de couplage électromécanique K$^2$, la courbe C7$_2$ est relative à la vitesse de propagation pour une surface dite libre, la courbe C7$_3$ est relative à la vitesse de propagation pour une surface métallisée, en fonction de l'épaisseur du film de Quartz.

La courbe C8$_1$ est relative à l'évolution du à l'évolution du coefficient de couplage électromécanique K$^2$, la courbe C8$_2$ est relative au coefficient de température de la fréquence (au 1er ordre), en fonction de l'épaisseur du film de Quartz.

Troisième exemple de substrat hybride :

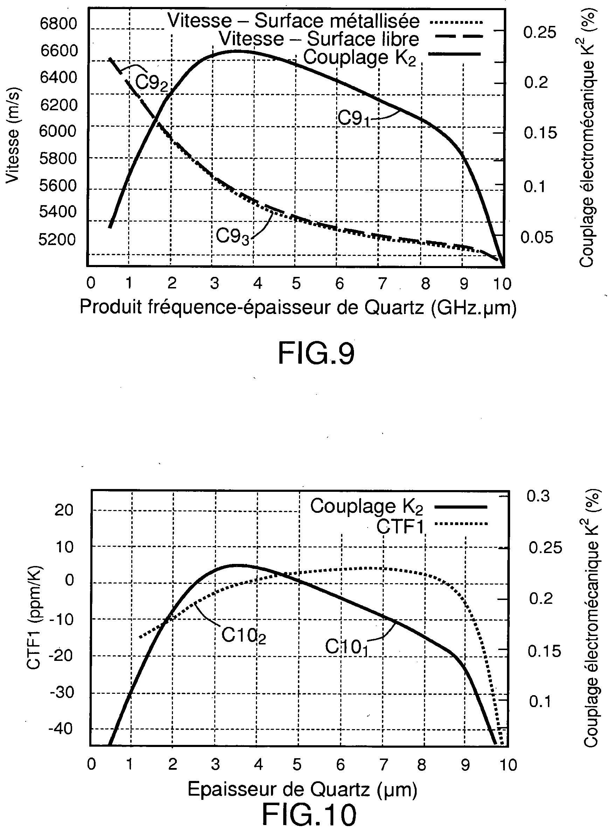

L'utilisation d'une couche de collage en or est également possible. L'or est un matériau particulièrement intéressant pour ce genre de collage, compte tenu de ses propriétés plastiques et de sa robustesse mécanique suffisante pour assurer une liaison acoustique entre le film piézoélectrique de quartz et le substrat de haute qualité acoustique de saphir. Le collage entre les deux substrats peut avantageusement être réalisé par thermo-compression. D'après les figures 9 et 10, les caractéristiques du mode sont légèrement moins favorables en termes de couplage que dans le cas d'une couche de SiO$_2$ mais sont plus intéressantes en terme de sensibilité à la température avec une compensation des effets de température (CTF = 0 ppm/K) obtenue au maximum de couplage $K^2$ ($\approx$ 0,23 %) pour une épaisseur de quartz d'environ 3,5 $\mu$m. Globalement, cette approche est également favorable à la réalisation de résonateurs sur ce type de substrat.

La courbe $C9_1$ est relative au coefficient de couplage électromécanique $K^2$, la courbe $C9_2$ est relative à la vitesse de propagation pour une surface dite libre, la courbe $C9_3$ est relative à la vitesse de propagation pour une surface métallisée, en fonction de l'épaisseur du film de quartz.

La courbe $C10_1$ est relative à l'évolution du à l'évolution du coefficient de couplage électromécanique $K^2$, la courbe $C10_2$ est relative au coefficient de température de la fréquence (au 1$^{er}$ ordre), en fonction de l'épaisseur du film de quartz.

Ainsi, l'utilisation de résonateurs réalisés sur ce type de substrat hybride peut avantageusement être envisagée dans des boucles d'oscillations destinées à la synthèse de fréquences ou de références de temps ultra-stables. Ce type de substrat hybride est de façon générale avantageux pour les filtres à bande étroite.

## Revendications

1. Dispositif à ondes élastiques de surface comprenant un empilement comportant au moins :

   - un film mince (10) réalisé en un premier matériau piézoélectrique ;
   - un substrat (20) réalisé en un second matériau ;
   - des moyens d'excitation pour générer au moins un mode de propagation d'ondes acoustiques de surface au niveau dudit film piézoélectrique ;
   où
   - le premier matériau est un matériau monocristallin et le second matériau est un matériau cristallin ;
   - l'épaisseur du film mince de premier matériau piézoélectrique étant comprise entre 1 et 20 $\mu$m ;
   - le premier matériau et le second matériau présentant des coefficients viscoélastiques inférieurs ou égaux à ceux du quartz pour le mode de propagation induit par les moyens d'excitation;
   - le premier matériau est l'un des matériaux suivants : quartz, $GaPO_4$, $SiO_2$ dopé, langasite (LGS - $La_3Ga_5SiO_{14}$), langatate (LGT - $La_3G_{5.5}Ta_{0.5}O_{14}$), langanite (LGN - $La_3Ga_{5.5}Nb_{0.5}O_{14}$, $Sr_3NbGa_3Si_2O_{14}$ (SNGS), $Ca_3NbGa_3Si_2O_{14}$ (CNGS), $Ca_3TaGa_3Si_2O_{14}$ (CTGS), $Sr_3TaGa_3Si_2O_{14}$ (STGS), ou $Ca_3TaAl_3Si_2O_{14}$ (CTAS);
   - le second matériau est l'un des matériaux suivants : saphir niobate de lithium, ou tantalate de lithium.

2. Dispositif à ondes élastiques de surface selon la revendication 1, **caractérisé en ce que** le second matériau est un matériau monocristallin.

3. Dispositif à ondes élastiques de surface selon l'une des revendications 1 ou 2, **caractérisé en ce que** l'épaisseur du film mince de premier matériau piézoélectrique est inférieure ou égale à 5 $\lambda$, $\lambda$ étant la longueur d'ondes acoustiques, pour les ondes de cisaillement transverses majoritaires.

4. Dispositif à ondes élastiques de surface selon l'une des revendications 1 ou 2, **caractérisé en ce que** l'épaisseur du film mince de premier matériau est inférieure ou égale à 2 $\lambda$, $\lambda$ étant la longueur d'ondes acoustiques, pour les ondes de polarisation majoritairement elliptiques.

5. Dispositif à ondes élastiques de surface selon l'une des revendications 1 à 4, **caractérisé en ce que** le film de premier matériau piézoélectrique est en contact direct avec le substrat réalisé dans le second matériau.

6. Dispositif à ondes élastiques de surface selon l'une des revendications 1 à 4, **caractérisé en ce qu'**il comprend au moins un film inorganique entre le film de premier matériau monocristallin et le substrat de second matériau.

7. Dispositif à ondes élastiques de surface selon la revendication 6, **caractérisé en ce qu'**il comprend un premier film inorganique intermédiaire entre le substrat et le film piézoélectrique, assurant le collage dudit film sur ledit substrat.

8. Dispositif à ondes élastiques de surface selon l'une des revendications 6 ou 7, **caractérisé en ce qu'**il comporte un second film intermédiaire en matériau métallique, situé entre le substrat et le film piézoélectrique, dont l'épaisseur et la nature du film permettent d'ajuster le coefficient de température de la fréquence du mode de propagation

9. Dispositif à ondes élastiques de surface selon la revendication 1, **caractérisé en ce que** le second matériau est saphir et présente une orientation cristalline de type C-plane, ou R-plane, ou M-plane ou A-plane.

**10.** Dispositif à ondes élastiques de surface selon la revendication 1, **caractérisé en ce que** :

- le substrat de niobate de lithium présente une coupe choisie parmi les suivantes: coupe (YX), coupe (YX*l*)/+ 41°, coupe (YX*l*)/ + 64°, coupe (YX*l*)/ + 128° avec une tolérance de $\pm 5°$ ou ;
- le substrat de tantalate de lithium présente une coupe choisie parmi les suivantes : coupe (XY), coupe (YX*l*)/ + 36°, coupe (YX*l*)/ + 42°, coupe (YX*l*)/+ $\theta$ avec $\theta$ compris entre 30° et 50°.

**11.** Résonateur comprenant un dispositif selon l'une des revendications précédentes.

**12.** Filtre de fréquence comprenant un dispositif selon l'une des revendications précédentes.

**13.** Procédé de fabrication d'un dispositif à ondes élastiques selon l'une des revendications 1 à 10, **caractérisé en ce qu'**il comprend :

- le transfert d·un premier substrat comprenant ledit premier matériau piézoélectrique sur un second substrat comprenant ledit second matériau ;
- une opération d'amincissement dudit premier substrat pour définir le film de premier matériau piézoélectrique ;
- la réalisation de moyens d'excitation dudit premier matériau piézoélectrique sur ledit film de premier matériau.

**14.** Procédé de fabrication d'un dispositif à ondes élastiques de surface selon la revendication 13, **caractérisé en ce que** l'étape de transfert comporte une étape de collage par collage hydrophile direct par l'intermédiaire d'une couche diélectrique en $SiO_2$ déposée sur le premier ou le second substrat.

**15.** Procédé de fabrication d'un dispositif à ondes élastiques de surface selon la revendication 13, **caractérisé en ce que** l'étape de transfert comporte une étape de collage par collage hydrophile direct ou par collage assisté par thermocompression, par l'intermédiaire d'une couche métallique, de l'or, déposée sur le premier ou le second substrat.

**Patentansprüche**

**1.** Vorrichtung mit elastischen Oberflächenwellen, die einen Stapel umfasst, der wenigstens Folgendes umfasst:

- einen dünnen Film (10) aus einem ersten, piezoelektrischen Material;
- ein Substrat (20) aus einem zweiten Material;
- Anregungsmittel zum Erzeugen wenigstens einer akustischen Oberflächenwellenausbreitungsmode an dem piezoelektrischen Film;

wobei:

- das erste Material ein monokristallines Material ist und das zweite Material ein kristallines Material ist;
- die Dicke des dünnen Films aus erstem, piezoelektrischem Material 1 bis 20 $\mu$m beträgt;
- das erste Material und das zweite Material Viskoelastizitätskoeffizienten haben, die gleich oder kleiner sind als die von Quarz für die von den Anregungsmitteln eingeführte Ausbreitungsmode;
- das erste Material eines der folgenden Materialien ist: Quarz, $GaPO_4$, dotiertes $SiO_2$, Langasit (LGS - $La_3Ga_5SiO_{14}$), Langatat (LGT - $La_3Ga_{5,5}Ta_{0,5}O_{14}$), Langanit (LGN - $La_3Ga_{5,5}Nb_{0,5}O_{14}$), $Sr_3NbGa_3Si_2O_{14}$ (SNGS), $Ca_3NBGa_3Si_2O_{14}$ (CNGS), $Ca_3TaGa_3Si_2O_{14}$ (CTGS), $Sr_3TaGa_3Si_2O_{14}$ (STGS) oder $Ca_3TaAl_3Si_2O_{14}$ (CTAS);
- das zweite Material eines der folgenden Materialien ist: Saphir, Lithiumniobat oder Lithiumtantalat.

**2.** Vorrichtung mit elastischen Oberflächenwellen nach Anspruch 1, **dadurch gekennzeichnet, dass** das zweite Material ein monokristallines Material ist.

**3.** Vorrichtung mit elastischen Oberflächenwellen nach Anspruch 1 oder 2, **dadurch gekennzeichnet, dass** die Dicke des dünnen Films aus erstem, piezoelektrischem Material gleich oder kleiner als 5 $\lambda$ ist, wobei $\lambda$ die Länge von akustischen Wellen ist, für majoritäre transversale Scherungswellen.

**4.** Vorrichtung mit elastischen Oberflächenwellen nach Anspruch 1 oder 2, **dadurch gekennzeichnet, dass** die Dicke des dünnen Films aus erstem Material gleich oder kleiner als 2 $\lambda$ ist, wobei $\lambda$ die Länge von akustischen Wellen ist, für hauptsächlich elliptische Polarisations wellen.

5. Vorrichtung mit elastischen Oberflächenwellen nach einem der Ansprüche 1 bis 4, **dadurch gekennzeichnet, dass** der Film aus erstem, piezoelektrischem Material mit der in dem zweiten Material realisierten Substrat in direktem Kontakt ist.

6. Vorrichtung mit elastischen Oberflächenwellen nach einem der Ansprüche 1 bis 4, **dadurch gekennzeichnet, dass** sie wenigstens einen anorganischen Film zwischen dem Film aus erstem, monokristallinem Material und dem Substrat aus zweitem Material umfasst.

7. Vorrichtung mit elastischen Oberflächenwellen nach Anspruch 6, **dadurch gekennzeichnet, dass** sie einen ersten, anorganischen Zwischenfilm zwischen dem Substrat und dem piezoelektrischen Film umfasst, der das Kleben des Films auf das Substrat gewährleistet.

8. Vorrichtung mit elastischen Oberflächenwellen nach Anspruch 6 oder 7, **dadurch gekennzeichnet, dass** sie einen zweiten Zwischenfilm aus metallischem Material umfasst, der sich zwischen dem Substrat und dem piezoelektrischen Film befindet, wobei Dicke und Beschaffenheit des Films das Justieren des Temperaturkoeffizienten der Frequenz der Ausbreitungsmode zulassen.

9. Vorrichtung mit elastischen Oberflächenwellen nach Anspruch 1, **dadurch gekennzeichnet, dass** das zweite Material Saphir ist und eine Kristallorientierung des Typs C-Ebene oder R-Ebene oder M-Ebene oder A-Ebene aufweist.

10. Vorrichtung mit elastischen Oberflächenwellen nach Anspruch 1, **dadurch gekennzeichnet, dass**:

     - das Lithiumniobat-Substrat einen Schnitt hat, ausgewählt aus den Folgenden: Schnitt (YX), Schnitt (YX*l*)/+ 41°, Schnitt (YX*l*)/ + 64°, Schnitt (YX*l*)/ + 128° mit einer Toleranz von $\pm$ 5° oder;
     - das Lithiumtantalat-Substrat einen Schnitt hat, ausgewählt aus den Folgenden: Schnitt (XY), Schnitt (YX*l*)/+ 36°, Schnitt (YX*l*)/ + 42°, Schnitt (YX*l*)/ + $\theta$, wobei $\theta$ zwischen 30° und 50° ist.

11. Resonator, der eine Vorrichtung nach einem der vorherigen Ansprüche umfasst.

12. Frequenzfilter, das eine Vorrichtung nach einem der vorherigen Ansprüche umfasst.

13. Verfahren zur Herstellung einer Vorrichtung mit elastischen Wellen nach einem der Ansprüche 1 bis 10, **dadurch gekennzeichnet, dass** es Folgendes beinhaltet:

     - Übertragen eines ersten Substrats, das das erste, piezoelektrische Material umfasst, auf ein zweites Substrat, das das zweite Material umfasst;
     - einen Vorgang des Verdünnens des ersten Substrats, um den Film aus dem ersten, piezoelektrischen Material zu definieren;
     - Realisieren von Mitteln zur Anregung des ersten, piezoelektrischen Materials auf dem Film aus dem ersten Material.

14. Verfahren zur Herstellung einer Vorrichtung mit elastischen Oberflächenwellen nach Anspruch 13, **dadurch gekennzeichnet, dass** der Übertragungsschritt einen Klebeschritt durch hydrophiles direktes Kleben mittels einer dielektrischen Schicht aus SiO$_2$ beinhaltet, abgesetzt auf das erste oder zweite Substrat.

15. Verfahren zur Herstellung einer Vorrichtung mit elastischen Oberflächenwellen nach Anspruch 13, **dadurch gekennzeichnet, dass** der Übertragungsschritt einen Klebeschritt durch hydrophiles direktes Kleben oder durch Thermokompressionsassistiertes Kleben, mittels einer metallischen Schicht aus Gold beinhaltet, abgesetzt auf das erste oder das zweite Substrat.

**Claims**

1. Surface elastic wave device comprising a stack comprising at least:

- a thin film (10) made of a piezoelectric first material;
- a substrate (20) made from a second material;
- excitation means for generating at least one surface acoustic wave propagation mode at the piezoelectric film; wherein:
- the first material is a single-crystal material and the second material is a crystalline material,
- the thickness of the thin film of piezoelectric first material being between 1 and 20 $\mu$m;
- the first material and the second material having viscoelastic coefficients less than or equal to those of quartz for the propagation mode induced by the excitation means;
- the first material is one of the following materials: quartz, $GaPO_4$, doped $SiO_2$, langasite (LGS - $La_3Ga_5SiO_{14}$), langatate (LGT - $La_3Ga_{5.5}Ta_{0.5}O_{14}$), langanite (LGN - $La_3Ga_{5.5}Nb_{0.5}O_{14}$), $Sr_3NbGa_3Si_2O_{14}$ (SNGS), $Ca_3NbGa_3Si_2O_{14}$ (CNGS), $Ca_3TaGa_3Si_2O_{14}$ (CTGS), $Sr_3TaGa_3Si_2O_{14}$ (STGS) or $Ca_3TaAl_3Si_2O_{14}$ (CTAS);
- the second material is one of the following materials: sapphire, lithium niobate or lithium tantalate.

2. Surface elastic wave device according to claim 1, **characterized in that** the second material is a single-crystal material.

3. Surface elastic wave device according to either claim 1 or 2, **characterized in that** the thickness of the thin film of piezoelectric first material is less than or equal to $5\lambda$, $\lambda$ being the acoustic wavelength for the predominant transverse shear waves.

4. Surface elastic wave device according to either claim 1 or 2, **characterized in that** the thickness of the thin film of first material is less than or equal to $2\lambda$, $\lambda$ being the acoustic wavelength for the primarily elliptical polarization waves.

5. Surface elastic wave device according to any one of claims 1 to 4, **characterized in that** the film of piezoelectric first material is in direct contact with the substrate made in the second material.

6. Surface elastic wave device according to any one of claims 1 to 4, **characterized in that** it comprises at least one inorganic film between the film of single-crystal first material and the substrate of second material.

7. Surface elastic wave device according to claim 6, **characterized in that** it comprises an intermediate inorganic first film between the substrate and the piezoelectric film, ensuring the bonding of the film to the substrate.

8. Surface elastic wave device according to either claim 6 or claim 7, **characterized in that** it comprises a second intermediate film made of metal material located between the substrate and the piezoelectric film, the thickness and nature of which film allow the frequency temperature coefficient of the propagation mode to be adjusted.

9. Surface elastic wave device according to claim 1, **characterized in that** the second material is sapphire and has a C-plane or R-plane or M-plane or A-plane crystal orientation.

10. Surface elastic wave device according to claim 1, **characterized in that**:

- the lithium niobate substrate has a cut chosen from the following: a (YX) cut, a (YX*l*)/+41° cut, a (YX*l*)/+64° cut, a (YX*l*)/+128° cut with a tolerance of $\pm 5°$ or;
- the lithium tantalate substrate has a cut chosen from the following: an (XY) cut, a (YX*l*)/+36° cut, a (YX*l*)/+42° cut, a (YX*l*)/+ $\theta$ cut where $\theta$ is between 30° and 50°.

11. Resonator comprising a device according to any one of the preceding claims.

12. Frequency filter comprising a device according to any one of the preceding claims.

13. Process for manufacturing an elastic wave device according to any one of claims 1 to 10, **characterized in that** it comprises:

- the transfer of a first substrate comprising the piezoelectric first material to a second substrate comprising the second material;
- an operation of thinning the first substrate in order to define the film of piezoelectric first material;
- producing means for exciting the piezoelectric first material on the film of first material.

**14.** Process for manufacturing a surface elastic wave device according to claim 13, **characterized in that** the transfer step comprises a step of bonding by direct hydrophilic bonding via a dielectric layer of $SiO_2$, deposited on the first or the second substrate.

**15.** Process for manufacturing a surface elastic wave device according to claim 13, **characterized in that** the transfer step comprises a step of bonding by direct hydrophilic bonding or by bonding assisted by thermocompression, via a metal layer of gold, deposited on the first or the second substrate.

FIG.1a

FIG.1b

10

30

20

**FIG.2a**

10

30

20

**FIG.2b**

10

30

20

**FIG.2c**

**FIG.2d**

**FIG.2e**

**FIG.2f**

FIG.3

Produit fréquence-épaisseur de Quartz (GHz.μm)

FIG.4

FIG.5

FIG.6

FIG.7

FIG.8

FIG.9

FIG.10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6933810 A

- US 20100156241 A

**Littérature non-brevet citée dans la description**

- **M. MIURA et al.** Temperature Compensated LiTaO3/Saphire Bonded SAW Substrate with Low Loss and High Coupling Factor Suitable for US-PCS Application. *IEEE Ultrasonics Symposium,* 2004
- **T. PASTUREAUD et al.** High-Frequency Surface Acoustic Waves Excited on Thin-Oriented LiNbO3 Single-Crystal Layers Transferred Onto Silicon. *IEEE Transactions on Ultrasonics,* 2007
- **J. LAMB ; J. RICHTER.** Anisotropic Acoustic Attenuation With New Measurements for Quartz at Room Temperature. *Proc. R. Soc. London, Ser.,* 1966, vol. A293, 479-492
- **T.E. PARKER ; J. A GREER.** SAW oscillators with Low Vibration Sensitivity. *Proc. of the 45th ASFC,* 1991, 321-329

- **D. ANDRES ; T. E. PARKER.** Designing smaller SAW oscillators for low vibration sensitivity. *Proc. of the IEEE IFCS,* 1994
- **AVRAMOV, I.D.** Low voltage, high performance, GHz range STW clocks with BAW crystal stability. *Frequency Control Symposium and Exposition, 2005. Proceedings of the 2005 IEEE International,* 29 Août 2005, 880, , 885
- **GROUSSET, S. ; AUGENDRE, E. ; BENAISSA, L. ; SIGNAMARCHEIX, T. ; BARON, T. ; COURJON, E. ; BALLANDRAS, S.** SAW pressure sensor based on single-crystal quartz layer transferred on Silicon. *European Frequency and Time Forum & International Frequency Control Symposium (EFTF/IFC), 2013 Joint,* 21 Juillet 2013, 980, , 983